Europäisches Patentamt

European Patent Office

Office européen des brevets

(11) Publication number: **0 066 810**
**B1**

# EUROPEAN PATENT SPECIFICATION

(45) Date of publication of patent specification: **12.10.88**

(21) Application number: **82104721.4**

(22) Date of filing: **28.05.82**

(51) Int. Cl.⁴: **H 01 L 21/74, H 01 L 29/40,
H 01 L 29/91, H 01 L 29/04,
H 01 L 29/72**

(54) Semiconductor device incorporated in a semiconductor layer formed on an insulating layer.

(30) Priority: **29.05.81 JP 82119/81
08.07.81 JP 106510/81**

(43) Date of publication of application:
**15.12.82 Bulletin 82/50**

(45) Publication of the grant of the patent:
**12.10.88 Bulletin 88/41**

(84) Designated Contracting States:
**DE FR GB**

(56) References cited:
**EP-A-0 024 905
DE-A-2 508 874
DE-A-2 631 880
DE-A-2 817 236
US-A-4 139 857
US-A-4 169 746**

(73) Proprietor: **KABUSHIKI KAISHA TOSHIBA
72, Horikawa-cho Saiwai-ku
Kawasaki-shi Kanagawa-ken 210 (JP)**

(72) Inventor: **Komatsu, Shigeru
209 Kamakura-Green-Mansion 436-1, Ueki
Kamakura-shi Kanagawa-ken (JP)**

(74) Representative: **Lehn, Werner, Dipl.-Ing. et al
Hoffmann, Eitle & Partner Patentanwälte
Arabellastrasse 4
D-8000 München 81 (DE)**

Courier Press, Leamington Spa, England.

## Description

The present invention relates to a semiconductor device comprising an insulating layer, a semiconductor layer of one conductivity type formed over said insulating layer, a first metal electrode formed in contact with said semiconductor layer, and a second metal electrode. Such a device is known from US—A—4 139 857, which is of the same patent family as DE—A—2631880.

A polycrystal silicon layer can be formed on an amorphous insulating film. Accordingly, a polycrystal silicon layer can be grown on a monocrystal silicon layer having elements formed therein, with an interlayer insulating film interposed therebetween. If semiconductor elements are formed in the polycrystal silicon layer thus layered, the resultant semiconductor elements are arranged in a three-dimensional fashion. This results in an improvement of the integration density of the semiconductor device. The polycrystal silicon can be grown at a relatively low temperature. Because of this natrure of the polycrystal silicon, the formation of the elements in the polycrystal silicon layer can be executed without any adverse influence on the elements already formed in the monocrystal silicon layer.

The sheet resistance of the impurity-doped polycrystal silicon layer is 5 to 50 times that of the impurity-doped monocrystal silicon layer when both are doped with the impurity under the same condition. In this respect, an element having a pn-junction formed in the polycrystal silicon layer grown in an insulating layer essentially has a problem with its characteristic.

For example, in the Schottky diode, the presence of the polycrystal silicon layer with a high sheet resistance raises a series resistance to deteriorate a voltage vs. current characteristic. In this connection, the ordinary diode has a contradictive problem in that when an impurity concentration in the polycrystal silicon layer is reduced to improve the backward breakdown voltage, the forward characteristic is deteriorated, while when the impurtiy concentration is raised to improve the forward characteristic, the backward breakdown voltage is soft in its characteristic curve. In the bipolar transistor formed in the polycrystal silicon layer grown on an insulating layer, a large series resistor is formed in the collector region. As a result, the desired characteristic can not be obtained.

In US—A—4 139 857, it is made clear that the semiconductor layer must be monocrystalline so that problems of using polycrystalline semiconductors do not arise.

An object of the present invention is to provide a semiconductor device employing a polycrystalline semiconductor layer and free from the charaacteristic problem due to the sheet resistance of the semiconductor layer on the insulating layer.

According to the invention, the device defined in the first paragraph of this specification is characterized in that said semiconductor layer is polycrystalline and in that an electrically conductive film of metal or a metal compound having a melting point not less than 900°C is formed between said insulating layer and the polycrystalline semiconductor layer such that said electrically conductive film is in contact with said polycrystalline semiconductor layer, and said second electrode is arranged in contact with said electrically conductive film or said polycrystalline semiconductor layer, whereby a current flowing between said first and second electrodes passes at least partially through said electrically conductive film to compensate for the relatively large sheet resistance of said polycrystalline semiconductor layer.

In such a physical arrangement, use of the electrically-conductive film with a high melting point can reduce the substantial series resistance in the semiconductor layer. This feature provides an improvement of the characteristic of the semiconductor device. Particularly, the current vs. voltage characteristic in the Schottky diode is improved. In the ordinary diode, even if the impurity concentration is reduced in order to improve the backward voltage, the presence of the high melting point metal film reduces the substantial sheet resistance. Therefore, the backward breakdown voltage and the forward characteristic are improved. Further, the series resistance in the collector region of transistors is reduced. As a result, the switching and amplifying characteristics, for example, are improved.

Other objects and advantages of this invention will become apparent from the following description taken in connection with the accompanying drawings, in which:

Fig. 1 shows a cross sectional view of a Schottky barrier diode formed in a polycrystal silicon layer according to the present invention;

Fig. 2 shows a graph illustrating current vs. voltage characteristics of the Schottky barrier diode of the present invention;

Fig. 3 shows a cross sectional view of another Schottky barrier diode according to the present invention;

Fig. 4 shows a cross sectional view of a diode formed in a polycrystal silicon layer according to the present invention;

Fig. 5 shows a current vs. voltage characteristic useful in explaining the advantages of the diode of the present invention;

Fig. 6 shows a cross sectional view of another diode according to the present invention; and

Fig. 7 shows a cross sectional view of a bipolar transistor formed in a polycrystal silicon layer according to the present invention.

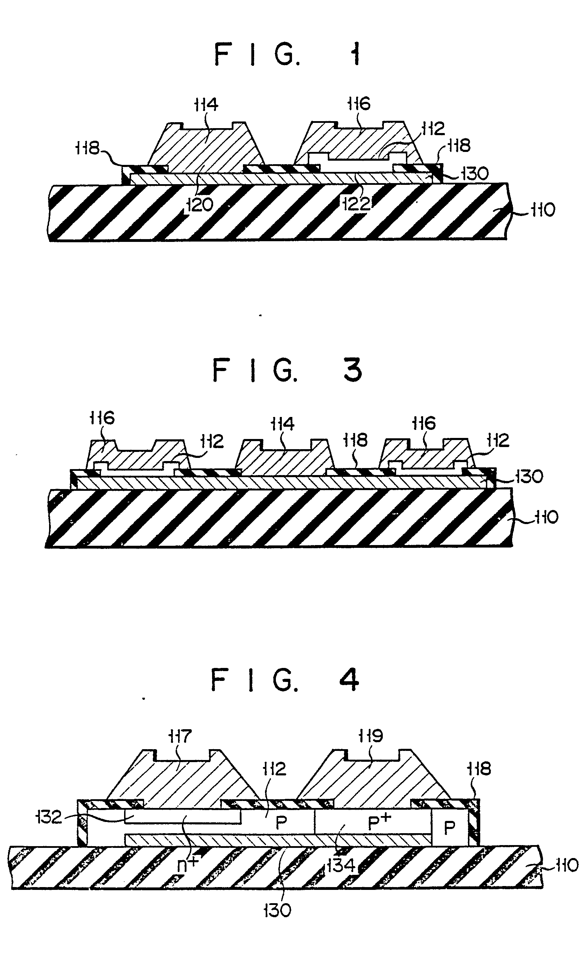

Referring to Fig. 1, an embodiment of a semiconductor device according to the present invention is illustrated. As shown, a metal silicide film 130, for example, a molybdenum silicide film of 200 to 300 nm (2,000 to 3,000 Å) in thickness, is formed on an insulating layer 110 made of $SiO_2$ or $Si_3N_4$ by a sputtering process. The molybdenum silicide film 130 is formed into a desired shape through a photo resist process and a plasma etching process. Then, it is annealed at a temperature of 1,000 to 1,100°C to have a resistance of about 3 to 4 ohms per square. An oxide film 118 of 200 to 300 nm (2,000 to 3,000 Å) in thickness is formed covering the film 130 by, for example, the CVD process. The annealing process of the oxide film 118 and the annealing process of the molybdenum silicide film 130 may be done in the same step. The oxide film 118 has openings formed therein 120 and 122 for cathode passing therethough. A polycrystal silicon layer 112 of 100 to 200 nm (1,000 to 2,000 Å) is formed in the opening 122, in order to form a Schottky barrier diode. N type impurity, for example, phosphorus, is implanted into the layer 112 by the ion implantation process.

Next, the polycrystal silicon layer 112 is annealed. Addition of the impurity into the polycrystal silicon layer 112 may be performed at the time of forming the polycrystal silicon layer 112. Electrode metal layers 114 and 116 made of aluminum, for example, may be formed in the opening 120 and on the polycrystal silicon layer 112, respectively. A Schottky junction is formed at the interface of the polycrystal silicon layer 112 and the electrode metal layer 116.

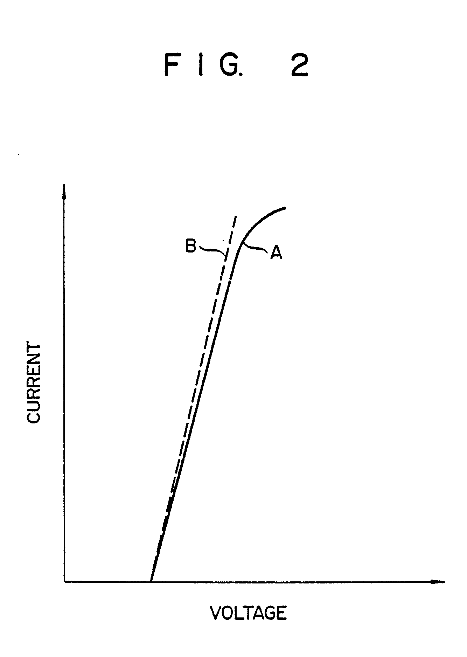

In a Schottky barrier diode with such a structure, the polycrystal silicon layer with a high resistance can be thinly formed so that the series resistance is low. Further, because a uniform current can be made to flow vertically, there is no locally centralized current flow. This brings about a high reliability of the semiconductor. A curve A in Fig. 2 shows a current vs. voltage characteristic of the Schottky barrier diode according to the present invention. A curve B indicated by a broken line indicates substantially the same characteristic as that of a Schottky barrier diode formed on monocrystal silicon.

While in the embodiment described above the molybdenum silicide film 130 is used for the electrode closer to the cathode, the electrode may be formed by using another metal silicide film or a heat resistive metal film with a high melting point, such as molybdenum, tungsten, titanium, or tantalum. The same effects are achieved.

The N type Schottky barrier diode used in the above-mentioned embodiment may be replaced by a P type Schottky barrier diode so that a platinum (pt) layer, for example, is formed on a P type semiconductor layer 112, and the platinum layer is silicided.

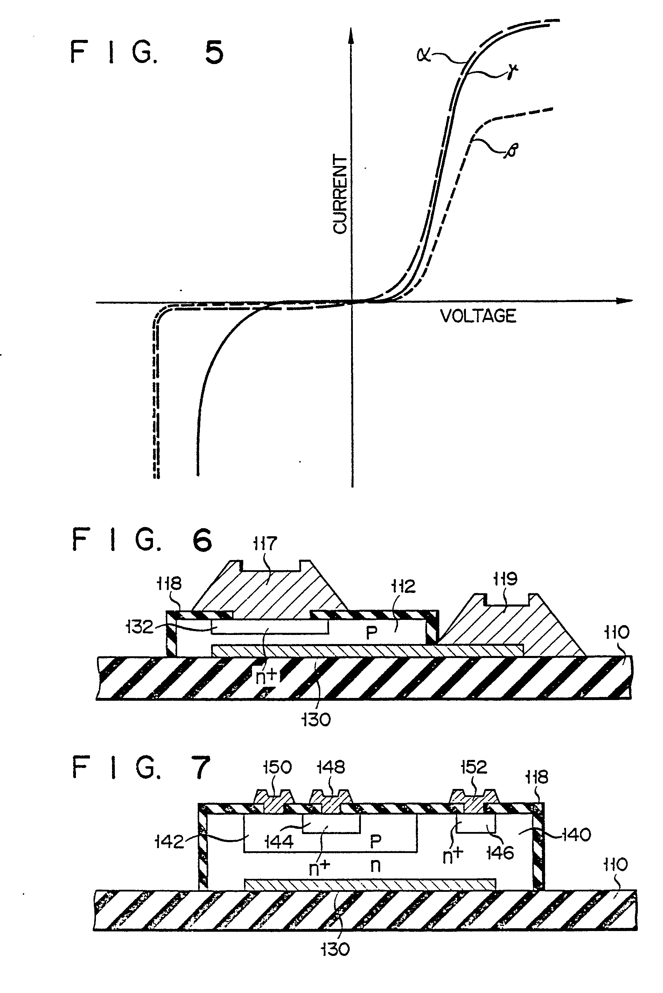

Fig. 3 shows a semiconductor device with a plurality of Schottky diodes. Like reference symbols used for designating like portions in Fig. 1.

A second embodiment of a semiconductor device according to the present invention will be described referring to Fig. 4. A land-shaped molybdenum silicide film 130 of 100 to 300 nm (1,000, to 3,000 Å) thickness is formed on an insulating layer 110 made of, for example, $SiO_2$ or $Si_3N_4$. The molybdenum silicide film 130 when annealed has a very small sheet resistance of 2 to 3 ohms per square. A land-shaped P type polycrystal silicon layer 112 of 500 to 1000 nm (5,000 to 10,000 Å) is formed on the insulating layer 110, entirely covering the molybdenum silicide film 130. An $n^+$ type impurity region 132 and a $p^+$ type impurity region 134 are formed in the polycrystal silicon layer 112 on the molybdenum silicide film 130. As shown, the $n^+$ type impurity region 132 diffused does not reach the molybdenum silicide film 130. The $n^+$ type impurity region 132 forms a pn junction in cooperation with its peripheral P type polycrystal silicon layer 112. The $p^+$ type impurity region 134 is diffused to a depth reaching the molybdenum silicide film 130. The surface of the silicon layer 112 is covered with a silicon oxide film 118. Formed on the silicon oxide film 118 are a cathode electrode 117 in ohmic-contact with the $n^+$ type impurity region 132 through a contact hole, and an anode 119 with the $p^+$ type impurity region 134 through another contact hole.

The land-shaped molybdenum silicide film 130 may be formed in an manner by which molybdenum silicide is deposited in a given thickness by the evaporation depositing process or the electron sputtering process. Its unnecessary portion is then selectively etched away. In a preferable formation of the land-shaped P type polycrystal silicon layer, a polycrystal silicon layer doped with no impurity is grown over the entire surface of the semiproduct up to a given thickness at 600 to 700°C by the CVD process. The polycrystal silicon layer is selectively etched to remove the unnecessary portion. The surface of the polycrystal silicon layer is then thermally oxidized to form the silicon oxide film 118. Next, boron is ion-implanted under the condition that the acceleration voltage is 40 to 80 KeV and the dosage is $5 \times 10^{13}$ to $2 \times 10^{14}$/cm². It is then activated at a temperature of 900 to 1,000°C. In this way, the poly-crystal silicon layer 112 of P conductivity type is formed. The P type polycrystal silicon layer 112 thus formed has a resistivity falling in a range from several kilo ohms.cm to several tens kilo ohms.cm. For doping impurity into the P type polycrystal silicon layer 112, the following processes may be employed instead of the ion implantation process. The first is the CVD process, conducted by mixing impurity into there reactive gas. The second is to thermally diffuse impurtiy from impurity-doped silicate glass into the polycrystal silicon layer 112. The third is to add impurity into the polycrystal silicon layer 112 by the liquid/solid phase thermal diffusion process. The ion implantation process, however, is most preferable because the concentration of impurity can be controlled.

For forming the $n^+$ type impurity region 132 and the $p^+$ type impurity region 134, a suitable process may be employed, such as thermal diffusion or ion implantation. If the insulating layer 110 is an interlayer insulating film formed on the monocrystal semiconductor layer having elements already formed, the ion implantation is preferable for forming the $n^+$ type impurity region 132. The $n^+$ impurity region 132 is formed in a manner that arsenic is ion-implanted into the polycrystal silicon layer 112 under the condition that the acceleration voltage is 100 KeV and the dosage is approximately $1 \times 10^{16}/cm^2$. The p$^+$ impurity region 134 is formed in a manner that boron is ion-implanted into the polycrystal silicon layer under the condition that the acceleration voltage is 50 to 80 KeV and the dosage is $1 \times 10^{15}$ to $1 \times 10^{16}/cm^2$. The n$^+$ type impurity region 132 and the p$^+$ type impurity region 134 are then activated at a temperature of 700 to 900°C. According to this method, the impurity regions 132 and 134 may be formed without any influence upon the semiconductor elements already formed.

The diode thus formed has a current vs. voltage characteristic indicated by a curve alpha (α) in Fig. 5. Curves beta (β) and gamma (γ) in the same graph indicate current-voltage characteristics of the diodes having no molybdenum silicide film 130.

Generally, the backward breakdown voltage of the diode largely depends on the impurity concentration in the impurity region forming the pn junction where the impurity concentration is lower. In the embodiment shown in Fig. 4, the impurity concentration of the polycrystal silicon layer 112 predominantly determines the backward breakdown voltage. In order to achieve a good backward breakdown voltage, it is necessary to control the impurity concentration of the polycrystal silicon layer 112. The impurity concentration of the polycrystal silicon layer 112 is preferably selected so that the sheet resistance is, for example, at least 5 kilo ohms per square.

In a diode having no molybdenum silicide film 130, when the impurity concentration of the polycrystal silicon layer 112 is decreased, that series resistance of the polycrystal silicon layer 112 is extremely high. In this case, the backward breakdown voltage is hard in its characteristic curve, but the forward characteristic is less than excellent, as indicated by the curve β. On the other hand, when the impurity concentration of the polycrystal silicon layer 112 is increased, the forward characteristic is satisfactory, but the backward breakdown voltage is soft and high in the leak level, as indicated by the curve gamma (γ).

The diode according to the present invention has the molybdenum silicide film 130 with a low sheet resistance disposed under the polycrystal silicon layer 112. Accordingly, in the case that the impurity concentration of the polycrystal silicon layer 112 is low and the sheet resistance of the polycrystal silicon layer 112 is high, the substantial series resistance can be kept low. The reason for this is that substantial series resistance from the anode electrode 119 to the n$^+$ type impurity region 132 is determined by the p$^+$ type impurity region 134 and the molybdenum silicide film 130. Most of the current flows into the molybdenum silicide film 130 with a small resistance, not into the polycrystal silicon layer 112 with a large resistance. Accordingly, a current vs. voltage characteristic of the curve alpha (α) with a hard backward breakdown voltage and a good forward characteristic can be obtained.

According to the present invention, even if the diode is formed in the polycrystal silicon layer formed through the interlayer insulating film on the monocrystal silicon layer, it is possible to prevent the characteristic of the diode from deteriorating. The above-mentioned embodiment is a diode with a pn junction by the n$^+$ type impurity region and p$^+$ type impurity region. It is evident that the present invention is applicable to a diode with a pn junction by the p$^+$ type impurity region and the n type impurity region.

A modification of a diode according to the present invention will be described referring to Fig. 6. In the present embodiment, the molybdenum silicide film 130 is partially formed beyond the polycrystal silicon layer 112. An anode electrode 119 is formed in contact with the extending portion of the molybdenum silicide film 130 beyond the polycrystal silicon layer 112. The structure of the remaining portion is similar to that of the Fig. 4 embodiment. Like reference numerals are used for the like portions in Fig. 6. No further explanation of the remaining structure will be given. The present embodiment employs the molybdenum silicide film 130 with an extremely small sheet resistance, thus attaining the same effects as those in the Fig. 4 embodiment.

A third embodiment of a semiconductor device according to the present invention will be described referring to Fig. 7. As shown in the figure, a land-shaped molybdenum silicide film 130 is formed on an insulating layer 110 made of, for example, $SiO_2$ or $Si_3N_4$. A land-shaped n type polycrystal silicon layer 140 is formed on the insulating layer 110 covering the entire of the molybdenum silicide film 130. A p type base region 142 is formed in the n type polycrystal silicon layer 140. An n$^+$ type emitter region 144 is formed in the p type base region 142. The n type polycrystal silicon layer 140 serves as a collector region of the bipolar transistor. An n$^+$ type impurity region 146 to be connected with the collector electrode 152 is formed in the collector region 140. The surface of the polycrystal silicon layer 140 is covered with an $SiO_2$ film 118 formed by thermal oxidation. An emitter electrode 148, a base electrode 150, and a collector electrode 152 which are in ohmic contact with the emitter region 144, the base region 142, and the n$^+$ type impurity region 146 through contact holes, are formed on the $SiO_2$ film 118.

Generally, the bipolar transistor formed in the polycrystal silicon layer has a larger series resistance in the collector region than that formed in the monocrystal silicon layer. Because of the series resistance, it is impossible for the former transistor to obtain a desirable characteristic. When the molybdenum silicide film 130 is formed as in the third embodiment, this problem can be solved.

The present invention may, of course, be applied to the pnp type bipolar transistors.

The molybdenum silicide film may be replaced by another metal silicide film, or by a refractory metal film with a high melting point such as molybdenum, tungsten, titanium, and tantalum.

The embodiments thus far described discuss the improvement of the semiconductor elements formed in the polycrystal silicon layer on the insulating layer. The series resistance is necessarily observed in the polycrystal silicon layer and ordinary semiconductor layer as well. Therefore, the present invention is applicable not only to semiconductor elements formed in the polycrystal silicon layer but also to semiconductor elements formed in a partially moncrystallized silicon layer or a monocrystal silicon layer. As a matter of course, the present invention is applicable to semiconductor elements formed in a semiconductor layer other than a silicon layer.

## Claims

1. A semiconductor device comprising an insulating layer (110), a semiconductor layer (112, 140) of one conductivity type formed over said insulating layer, a first metal electrode (116, 117, 150) formed in contact with said semiconductor layer, and a second metal electrode (114, 119, 152), characterized in that said semiconductor layer (112, 140) is polycrystalline and in that an electrically conductive film (130) of metal or a metal compound having a melting point not less than 900°C is formed between said insulating layer and the polycrystalline semiconductor layer (112, 140) such that said electrically conductive film (130) is in contact with said polycrystalline semiconductor layer, and said second electrode is arranged in contact with said electrically conductive film (130) or said polycrystalline semiconductor layer (112, 140), whereby a current flowing between said first and second electrodes passes at least partially through said electrically conductive film to compensate for the relatively large sheet resistance of said polycrystalline semiconductor layer.

2. A semiconductor device according to claim 1 wherein one end of said electrically conductive film (130) is connected to said polycrystalline semiconductor layer (112), and the other end of said electrically conductive layer (130) is connected to said second electrode (114), and a Schottky barrier is formed between said polycrystalline semiconductor layer (112) and said first electrode (116).

3. A semiconductor device according to claim 1 wherein a plycrystalline semiconductor region (132) of the other conductivity type is formed in said polycrystalline semiconductor layer (112) such that said polycrystalline semiconductor region (132) is separated from said electrically conductive film (130) with said polycrystalline semiconductor layer (112) interposed between said electrically conductive film (130) and said polycrystalline semiconductor region (132) so as to form a PN junction between said polycrystalline semiconductor region and said polycrystalline semiconductor layer, said first electrode (117) being formed in contact with said polycrystalline semiconductor region (132), and said second electrode (119) being formed in contact with said polycrystalline semiconductor layer (112).

4. A semiconductor device according to claim 1 wherein a polycrystalline semiconductor region (132) of the other conductivity type is formed in said polycrystalline semiconductor layer (112) such that said polycrystalline semiconductor region (132) is separated from said electrically conductive film (130) with said polycrystalline semiconductor layer (112) interposed between said electrically conductive film (130) and said polycrystalline semiconductor region (132) so as to form a PN junction between said polycrystalline semiconductor region and said polycrystalline semiconductor layer, said first electrode (117) being formed in contact with said polycrystalline semiconductor region (132), and said second electrode (119) being formed in contact with said electrically conductive film (130).

5. A semiconductor device according to claim 1 wherein a first polycrystalline semiconductor region (142) of the other conducivity type serving as a base is formed in said polycrystalline semiconductor layer (140) which serves as a collector, a second polycrystalline semiconductor regions (144) of one conductivity type serving as an emitter is formed in said first polycrystalline semiconductor region (142), said first electrode (150) is connected to said first polycrystalline semiconductor region (142), said second electrode (152) being connected to said polycrystalline semiconductor layer (140), a third metal electrode (148) being connected to said second polycrystalline semiconductor region (144), and said electrically conductive film (130) being separated from said first polycrystalline semiconductor region (142) with said polycrystalline semiconductor layer (140) interposed between said electrically conductive film (130) and said first polycrystalline semiconductor region (142).

6. A semiconductor device according to any one of claims 1 to 5 wherein said electrically conductive film is made of metal silicide.

## Patentansprüche

1. Halbleiteranordnung enthaltend: eine Isolierschicht (110), eine über dieser Isolierschicht gebildete Halbleiterschicht (112, 140) eines Leitfähigkeittyps, eine erste in Kontakt mit der Halbleiterschicht stehende Metallelektrode (116, 117, 150) und eine zweite Metallelektrode (114, 119, 152), dadurch gekennzeichnet, daß die Halbleiterschicht (112, 140) polykristallin ist und daß ein elektrisch leitfähigher Film (130) aus Metall oder einer Metallverbindung mit einem Schmelzpunkt nicht weniger als 900°C zwischen der Isolierschicht und der polykristallinen Halbeiterschicht (112, 140) derart gebildet ist, daß der elektrisch leitfähige Film (130) in Kontakt mit der polykristallinen Halbleiterschicht steht, und die zweite Elektrode in Kontakt mit dem elektrisch leitfähigen Film (130) oder der polykristallinen Halbleiter-

9  **0 066 810**  10

schicht (112, 140) angeordnet ist, wodurch ein zwischen den ersten und zweiten Elektroden fließender Strom wenigstens teilweise durch den elektrisch leitfähigen Film fließt, um den relativ großen Schichtwiderstand der polykristallinen Halbleiterschicht zu kompensieren.

2. Halbleiteranordnung nach Anspruch 1, dadurch gekennzeichnet, daß ein Ende des elektrisch leitfähigen Films (130) mit der zweiten Elektrode (114) verbunden ist, und eine Schottky-Barriere zwischen der polykristallinen Halbleiterschicht (112) und der ersten Elektrode (116) gebildet ist.

3. Halbleiteranordnung nach Anspruch 1, dadurch gekennzeichnet, daß ein polykristalliner Halbleiterbereich (132) des anderen Leitfähigkeitstyps in der polykristallinen Halbleiterschicht (112) derart gebildet ist, daß der polykristalline Halbleiterbereich (132) von dem elektrisch leitfähigen Film (130) getrennt ist und der polykristalline Halbleiterschicht (112) zwischen dem elektrisch leitfähigen Film (130) und dem polykristallinen Halbleiterbereich (132) angeordnet ist, um einen PN-Übergang zwischen dem polykristallinen Halbleiterbereich und der polykristallinen Halbleiterschicht zu bilden, wobei die erste Elektrode (117) in Kontakt mit dem polykristallinen Halbleiterbereich (132) und die zweite Elektrode (119) in Kontakt mit der polykristallinen Halbleiterschicht (112) gebildet ist.

4. Halbleiteranordnung nach Anspruch 1, dadurch gekennzeichnet, daß ein polykristalliner Halbleiterbereich (132) des anderen Leitfähigkeitstyps in der polykristallinen Halbleiterschicht (112) derart gebildet ist, daß der polykristalline Halbleiterbereich (132) vom elektrisch leitfähigen Film (130) getrennt ist und die polykristalline Halbleiterschicht zwischen dem elektrisch leitfähigen Film (130) und dem polykristallinen Halbleiterbereich (132) angeordnet ist, um einen PN-Übergang zwischen dem polykristallinen Halbleiterbereich und der polykristallinen Halbleiterschicht zu bilden, wobei die erste Elektrode (117) in Kontakt mit dem polykristallinen Halbleiterbereich (132) und die zweite · Elektrode (119) in Kontakt mit dem elektrisch leitfähigen Film (130) gebildet ist.

5. Halbleiteranordnung nach Anspruch 1, dadurch gekennzeichnet, daß ein erster als Basis dienender polykristalliner Halbleiterbereich (142) des anderen Leitfähigkeitstyps in der als Kollektor dienenden polykristallinen Halbleiterschicht (140) und ein zweiter polykristalliner als Emitter dienender Halbleiterbereich (144) eines Leitfähigkeitstyps in dem ersten polykristallinen Halbleiterbereich (142) gebildet ist, die erste Elektrode (150) mit dem ersten polykristallinen Halbleiterbereich (145) verbunden ist, wobei die zweite Elektrode (142) mit der polykristallinen Halbleiterschicht (140) und eine dritte Metallelektrode (148) mit dem zweiten polykristallinen Halbleiterbereich (144) verbunden ist und der elektrisch leitfähige Film (130) von dem ersten polykristallinen Halbleiterbereich (142) getrennt ist und die polykristalline Halbleiterschicht (140) zwischen dem elektrisch leitfähigen Film (130) und dem ersten polykristallinen Halbleiterbereich (142) angeordnet ist.

6. Halbleiteranordnung nach einem der Ansprüche 1 bis 5, dadurch gekennzeichnet, daß der elektrisch leitfähige Film aus Matallsilizid ist.

**Revendications**

1. Dispositif à semi-conducteur, comprenant une couche isolante (110), une couche semi-conductrice (112, 140) d'un premier type de conductivité, formée sur la couche isolante, une première électrode métallique (116, 117, 150) formée au contact de la couche semi-conductrice, et une seconde électrode métallique (114, 119, 152), caractérisé en ce que la couche semi-conductrice (112, 140) est polycristalline, et en ce qu'un film (130) conducteur de l'électricité, formé d'un métal ou d'un composé métallique ayant une température de fusion qui n'est pas inférieure à 900°C, est formé entre la couche isolante et la couche semi-conductrice polycristalline (112, 140) si bien que le film (130) conducteur de l'électricité est au contact de la couche semi-conductrice polycristalline, et la seconde électrode est disposée au contact du film (130) conducteur de l'électricité ou de la couche semi-conductrice polycristalline (112, 140), si bien qu'un courant circulant entre la première et la seconde électrode circule au moins en partie dans le film conducteur de l'électricité, et que l'effet de la résistance laminaire relativement grande de la couche semi-conductrice polycristalline est compensé.

2. Dispositif à semi-conducteur selon la revendication 1, dans lequel une première extrémité du film (130) conducteur de l'électricité est reliée à la couche semiconductrice polycristalline (112), et l'autre extrémité du film (130) conducteur de l'électricité est reliée à la seconde électrode (114), et une barrière de Schottky est formée entre la couche semi-conductrice polycristalline (112) et la première électrode (116).

3. Dispositif à semi-conducteur selon la revendication 1, dans lequel une région semi-conductrice polycristalline (132) ayant l'autre type de conductivité est formée dans la couche semi-conductrice polycristalline (112) afin que la région semi-conductrice polycristalline (132) soit séparée du film (130) conducteur de l'électricité par la couche semi-conductrice polycristalline (112) placée entre le film (130) conducteur de l'électricité et la région semi-conductrice polycristalline (132), si bien qu'une jonction PN est formée entre le région semi-conductrice polycristalline et la couche semi-conductrice polycristalline, la première électrode (117) étant formée au contact de la région semi-conductrice polycristalline (132), la seconde électrode (119) étant formée au contact de la couche semi-conductrice polycristalline (112).

4. Dispositif à semi-conducteur selon la revendication 1, dans lequel une région semi-conductrice polycristalline (132) ayant l'autre type de conductivité est formée dans la couche semi-conductrice polycristalline (112) afin que la région

6

semi-conductrice polycristalline (132) soit séparée du film (130) conducteur de l'électricité par la couche semi-conductrice polycristalline (112) placée entre la film (130) conducteur de l'électricité et la région semi-conductrice polycristalline (132), si bien qu'une jonction PN est formée entre la région semi-conductrice polycristalline et la couche semi-conductrice polycristalline, le première électrode (117) étant formée au contact de la région semi-conductrice polycristalline (132) et la seconde électrode (119) étant formée au contact du film (130) conducteur de l'électricité.

5. Dispositif à semi-conducteur selon la revendication 1, dans lequel une première région semi-conductrice polycristalline (142) ayant l'autre type de conductivité et jouant le rôle d'une base est formée dans la couche semi-conductrice polycristalline (140) qui joue le rôle d'un collecteur, une seconde région semi-conductrice polycristalline (144) du premier type de conductivité jouant le rôle d'un émetteur est formée dans la première région semi-conductrice polycristalline (142), et la première électrode (150) est reliée à la première région semi-conductrice polycristalline (142), la seconde électrode (152) étant reliée à la couche semi-conductrice polycristalline (140), une troisième électrode metallique (148) étant reliée à la seconde région semi-conductrice polycristalline (144), et le film (130) conducteur de l'électricité étant séparé de la première région semi-conductrice polycristalline (142) par la couche semi-conductrice polycristalline (140) disposée entre le film (130) conducteur de l'électricité et la prmière région semi-conductrice polycristalline (142).

6. Dispositif à semi-conducteur selon l'une quelconque des revendications 1 à 5, dans lequel le film conducteur de l'électricité est formé d'un siliciure métallique.

# F I G.  1

# F I G.  3

# F I G.  4

# F I G. 2

F I G. 5

CURRENT

α

γ

β

VOLTAGE

F I G. 6

117

118

112

119

132

P

110

n+

130

F I G. 7

150  148

152  118

142

144

P

140

n+

n

n+  146

110

130